**Europäisches Patentamt**

**European Patent Office**

**Office européen des brevets**

(11) Veröffentlichungsnummer: **0 417 348 A1**

# (12) EUROPÄISCHE PATENTANMELDUNG

(21) Anmeldenummer: **89117139.9**

(22) Anmeldetag: **15.09.89**

(51) Int. Cl.5: **H01L 21/74**, H01L 21/22, H01L 21/225, H01L 21/82, H01L 27/144

(43) Veröffentlichungstag der Anmeldung:
**20.03.91 Patentblatt 91/12**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**W-8000 München 2(DE)**

(72) Erfinder: **Lauterbach, Christl**
**Rosenstrasse 6**
**W-8011 Siegertsbrunn(DE)**
Erfinder: **Bauer, Josef-Georg, Dipl.-Ing.**
**Eglersried 5**
**W-8062 Markt Indersdorf(DE)**

(54) **Verfahren zur Herstellung eines dotierten Bereiches in einer Halbleiterschicht.**

(57) Verfahren zur Herstellung eines dotierten Bereichs (8) in einer Epitaxieschicht (2) eines Halbleiterbauelements, wobei vor der Epitaxie der Dotierstoff in das Substrat (1) eindiffundiert wird und nach dem Aufwachsen der Epitaxieschicht (2) in einem Hochtemperaturprozeß eine Ausdiffusion des Dotierstoffes aus dem Substrat (1) in den zu dotierenden Bereich (8) bewirkt wird.

FIG 1

FIG 2

FIG 3

EP 0 417 348 A1

# VERFAHREN ZUR HERSTELLUNG EINES DOTIERTEN BEREICHES IN EINER HALBLEITERSCHICHT

Bei der Integration von verschiedenen Halbleiter-Bauelementen auf einem Substrat stellt sich das Problem der Kompatibilität der benötigten Schichtfolgen für die Einzelkomponenten. Gängige Verfahren bei III-V-Halbleitern zur Erzeugung von lokalen Dotierungsgebieten sind Diffusion oder Ionenimplantation. Eine Anwendung dieser Techniken ist die Ausbildung von Bereichen, die eine elektrische Isolationswirkung besitzen. Damit kann ein Über- und Nebensprechen sowie eine Beeinflussung anderer Bauelemente stark reduziert werden.

Die Realisierung von dotierten Bereichen innerhalb von verschiedenen Halbleiterschichten ist meist sehr aufwendig. Ist dies innerhalb von Epitaxieschichten notwendig, so wird in der Mehrzahl der Fälle eine Unterbrechung bei dem epitaktischen Wachstumsprozeß notwendig. So wird nach einer ersten Epitaxie das Schichtwachstum unterbrochen und mit Hilfe von strukturierten Oxid- bzw. Nitridschichten lokale Bereiche dotiert. Nach der Entfernung der Maske wird die Epitaxie fortgesetzt. Diese Unterbrechung birgt die Gefahr einer ungewollten Kontamination mit Dotierstoffen innerhalb der Halbleiterschichten, die zu einer Verschlechterung der Qualität führt. Außerdem wird aus den lokalen Dotierungsgebieten durch den nachfolgenden Hochtemperaturprozeß eine meist störende Ausdiffusion der Ladungsträger in benachbarte Halbleiterschichten induziert.

Aufgabe der vorliegenden Erfindung ist es, ein Herstellungsverfahren für dotierte Bereiche in epitaktisch aufgewachsenen Halbleiterschichten eines Halbleiterbauelementes anzugeben, bei dem der Epitaxieprozeß zum Aufwachsen der Schichten nicht unterbrochen zu werden braucht.

Diese Aufgabe wird mit dem Verfahren mit den Merkmalen des Anspruchs 1 gelöst. Weitere Ausgestaltungen ergeben sich aus den Unteransprüchen.

Es folgt eine Beschreibung eines exemplarischen Herstellungsverfahrens gemäß der vorliegenden Erfindung anhand der Figuren 1 bis 3.

Figuren 1 und 2 zeigen ein erfindungsgemäß bearbeitetes Halbleiterbauelement nach zwei verschiedenen Prozeßschritten im Querschnitt.

Fig. 3 zeigt ein komplettes nach dem erfindungsgemäßen Herstellungsverfahren hergestelltes Bauelement im Querschnitt.

Grundlage für das erfindungsgemäße Herstellungsverfahren ist die Beobachtung, daß im Verlauf von Hochtemperaturprozessen bereits in ein Bauelement eingebrachte Dotierung in benachbarte Halbleiterschichten ausdiffundiert. Bei dem hier beschriebenen Verfahren wird dieses Ausdiffundieren gezielt zum Ausbilden von dotierten Bereichen in Epitaxieschichten ausgenutzt. Bei diesem Hochtemperaturprozeß kann es sich z. B. um einen nachfolgenden Epitaxieschritt, einen nachfolgenden Diffusionsprozeß oder das Ausheilen des Halbleiters nach der Implantation handeln. Mit Hilfe dieser Ausdiffusion können vorhergehende oder nachfolgende Halbleiterschichten dotiert werden.

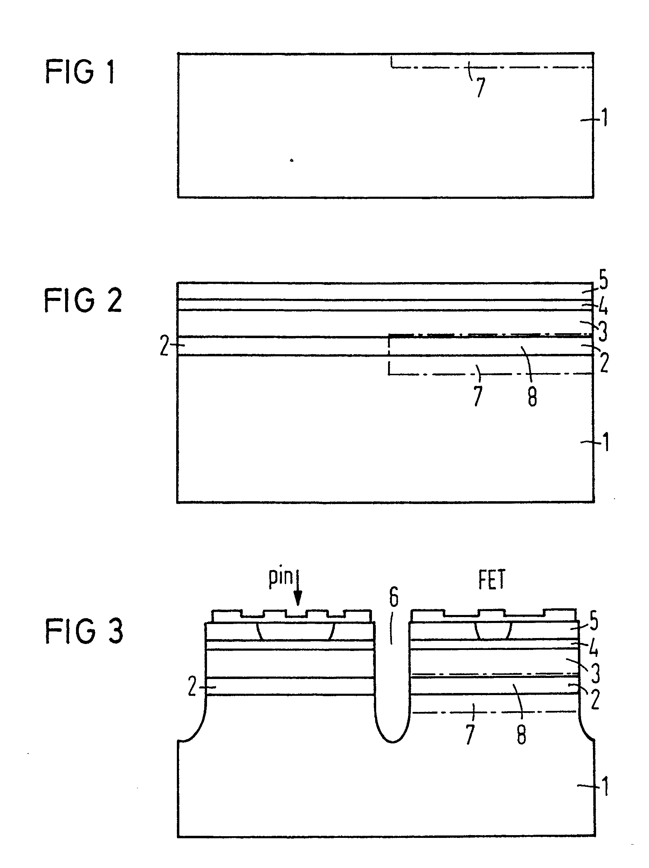

Fig. 1 zeigt ein Substrat 1 aus einem Halbleitermaterial (z. B. InP), auf das eine erste Epitaxieschicht 2 und gegebenenfalls weitere Epitaxieschichten 3, 4, 5 aufgewachsen werden sollen. Diese erste Epitaxieschicht 2 soll mit einem ersten dotierten Bereich 8 versehen werden. Das erfindungsgemäße Verfahren ist auch entsprechend anwendbar, wenn die weiteren Epitaxieschichten 3, 4, 5 vor dieser ersten Epitaxieschicht 2 oder nach der ersten Epitaxieschicht 2 aufgewachsen werden, oder die erste Epitaxieschicht 2 kann sich zwischen den weiteren Epitaxieschichten 3, 4, 5 befinden. Um die Dotierung des ersten dotierten Bereiches 8 in der ersten Epitaxieschicht 2 zu bewirken, wird in dem Substrat 1 ein zweiter dotierter Bereich 7 ausgebildet, was z. B. durch Einbringen von Dotierstoffen mittels Diffusion oder Implantation erfolgen kann und vor dem Aufwachsen der ersten Epitaxieschicht 2 erfolgt.

In Fig. 2 ist das Bauelement mit der ersten Epitaxieschicht 2 und den weiteren Epitaxieschichten 3, 4, 5 im Querschnitt dargestellt. Während des Epitaxieprozesses und der dabei auftretenden Erwärmung des Substrates 1 ist ein Teil des Dotierstoffes aus den ersten dotierten Bereich 7 in den zweiten dotierten Bereich 8 der ersten Epitaxieschicht 2 ausdiffundiert. Fig. 3 zeigt ein fertig hergestelltes Bauelement, bei dem das Funktionselement mit dem ersten dotierten Bereich 8 durch einen Trenngraben 6 von weiteren auf dem Substrat 1 aufgebrachten Funktionselementen getrennt ist. In diesem Fall befindet sich die erste Epitaxieschicht 2 als Pufferschicht unmittelbar auf dem Substrat 1 und ist auch die erste epitaktisch aufgewachsene Schicht. Als Dotierstoff kommt für InP z. B. Zink in Frage.

Eine besonders vorteilhafte Anwendung des erfindungsgemäßen Herstellungsverfahrens ergibt sich beim Aufwachsen verschiedener Mischkristall-Zusammensetzungen. In dem Beispiel mit einem Substrat 1 aus InP kann z. B. eine ternäre Schicht aus InGaAs aufgewachsen sein (Schicht 3 in Figuren 1 und 3). Wegen des unterschiedlichen Diffusionskoeffizienten dieses ternären Materials im Gegensatz zu dem binären InP wird das Ausdiffundieren des Dotierstoffes aus dem Substrat 1 in die erste Epitaxieschicht 2 an dieser speziellen weiteren Epitaxieschicht 3 aus ternärem Material gestoppt. Damit ist es möglich, den Diffusionsvorgang in den ersten dotierten Bereich 8 zu steuern. Statt nur eines Bereiches können auf diese Weise auch mehrere verschiedene, z. B. lokal begrenzte Bereiche in verschiedenen Epitaxieschichen dotiert werden. Der Vorteil ist, daß der Epitaxieprozeß nicht unterbrochen zu werden braucht. Bei komplizierteren Aufbauten mit mehreren dotierten Bereichen in verschiedenen Epitaxieschichten braucht der Epitaxieprozeß weniger oft unterbrochen zu werden als bei den herkömmlichen Herstellungsverfahren. Es ist z. B. möglich, eine zentrale Eptiaxieschicht (z. B. Schicht 3 in Fig. 2) mit dem Dotierstoff zu versehen. Das Ausbilden von dotierten Bereichen in den darüberliegenden und darunterliegenden Schichten kann dann durch Diffusion geschehen, wobei die Dotierungskonzentrationen und die vertikale Ausdehnung dieser dotierten Bereiche wieder durch begrenzende Schichten mit unterschiedlichen Dotierungskoeffizienten gesteuert werden können. Die Dotierungskonzentration der zu dotierenden Bereiche und die Dotierungsprofile können durch die Dauer des Hochtemperaturprozesses und die dabei eingestellte Temperatur gesteuert werden.

Ansprüche

1. Verfahren zur Herstellung mindestens eines ersten dotierten Bereiches (8) in einer ersten Epitaxieschicht (2) eines Halbleiterbauelements durch Einbringen von Dotierstoff,
dadurch gekennzeichnet,
- daß das Einbringen des Dotierstoffs vor dem Aufwachsen dieser ersten Epitaxieschicht (2) erfolgt,
- daß durch das Einbringen des Dotierstoffes ein zweiter dotierter Bereich (7) hergestellt wird,
- daß nach dem Einbringen des Dotierstoffes ein Hochtemperaturprozeß durchgeführt wird,
- daß durch diesen Hochtemperaturprozeß eine Diffusion des Dotierstoffes aus dem zweiten dotierten Bereich (7) bewirkt wird und
- daß die Anordnung des zweiten dotierten Bereichs (7) in bezug auf den ersten dotierten Bereich (8) so vorgenommen ist, daß durch diese Diffusion des Dotierstoffes eine Dotierung des ersten dotierten Bereichs (8) mit einer vorgesehenen Dotierungskonzentration und einem vorgesehenen Dotierungsprofil erfolgt.
2. Verfahren nach Anspruch 1,
dadurch gekennzeichnet,
- daß der zweite dotierte Bereich (7) in einem Substrat (1) ausgebildet wird und
- daß die erste Epitaxieschicht (2), in der der erste dotierte Bereich (8) ausgebildet wird, als Pufferschicht auf das Substrat aufgewachsen wird.

3. Verfahren nach Anspruch 1 oder 2,
dadurch gekennzeichnet,
- daß mindestens eine weitere Epitaxieschicht (3, 4, 5) aufgewachsen wird und
- daß mindestens eine spezielle weitere Epitaxieschicht (3) eine Zusammensetzung mit einem derartigen Diffusionskoeffizienten hat, daß die Diffusion von Dotierstoff aus dem zweiten dotierten Bereich (7) an dieser speziellen weiteren Epitaxieschicht (3) gestoppt wird.
4. Verfahren nach Anspruch 3,
dadurch gekennzeichnet,
- daß die erste Epitaxieschicht (2) InP ist und
- daß die spezielle weitere Epitaxieschicht (3) InGaAs ist.
5. Verfahren nach einem der Ansprüche 1 bis 4,
dadurch gekennzeichnet,
daß das Aufwachsen der Epitaxieschichten (2, 3, 4, 5) ohne Unterbrechung erfolgt.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | IBM TECHNICAL DISCLOSURE BULLETIN, Band 16, Nr. 6, November 1973, Seite 1758, New York, US; W.P. DUMKE et al.: "Room temperature laser array with buried diffused stripes"<br>--- | 1,5 | H 01 L 21/74<br>H 01 L 21/22<br>H 01 L 21/225<br>H 01 L 21/82<br>H 01 L 27/144 |
| A | IDEM<br>--- | 2 | |
| A | PATENT ABSTRACTS OF JAPAN, Band 9, Nr. 39 (E-297)[1762], 19. Februar 1985; & JP-A-59 181 055 (FUJITSU K.K.) 15-10-1984<br>* Zusammenfassung; Fig. *<br>--- | 1-5 | |
| A | EP-A-0 260 376 (LICENTIA PATENT-VERWALTUNGS-GmbH)<br>* Fig. 1; Seite 3, Zeile 20 - Seite 6, Zeile 11 *<br>--- | 1-5 | |
| A | EP-A-0 258 530 (LICENTIA PATENT-VERWALTUNGS-GmbH)<br>* Fig. 3; Seite 2, Zeile 30 - Seite 3, Zeile 19 *<br>--- | 1-5 | **RECHERCHIERTE SACHGEBIETE (Int. Cl.5)** |
| A | APPLIED PHYSICS LETTERS, Band 55, Nr. 9, 28. August 1989, Seiten 876-878, American Institute of Physics, New York, US; F. DILDEY et al.: "Replacement of magnesium in InGaAs/InP heterostructures during zinc diffusion"<br>* Seite 876; Fig. 2 *<br>----- | 1,3,4 | H 01 L |

Der vorliegende Recherchenbericht wurde für alle Patentansprüche erstellt

| Recherchenort | Abschlußdatum der Recherche | Prüfer |
|---|---|---|
| DEN HAAG | 08-05-1990 | GELEBART J.F.M. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
 
& : Mitglied der gleichen Patentfamilie, übereinstimmendes Dokument